# FASCICULE DE BREVET EUROPEEN

(11) **EP 0 638 913 B1**
(45) Date de publication et mention de la délivrance du brevet: **08.01.1997**
(21) Numéro de dépôt: 94401835.7
(22) Date de dépôt: 10.08.1994
(51) Int. Cl.: H01H 9/16, F02K 1/76

(54) **Circuit de détection de la position de plusieurs contacteurs bipolaires et application à un inverseur de poussée d'un turboréacteur**
Schalterstellungsdetektionskreis für die Stellung mehrerer bipolarer Schalter und Anwendung bei einem Schubumkehrer eines Strahltriebwerks
Detection circuit for the switch position of several bipolar switches and application for a jet engine thrust reverser

(30) Priorité: 12.08.1993 FR 9309895
(43) Date de publication de la demande: 15.02.1995
(73) Titulaire: SOCIETE NATIONALE D'ETUDE ET DE CONSTRUCTION DE MOTEURS D'AVIATION, "S.N.E.C.M.A.", F-75015 Paris (FR)
(72) Inventeur: Halin, Yves Robert, F-91250 St Germain Les Corbeil (FR); Pean, Eric Charles, F-77310 Saint Fargeau Ponthierry (FR)

(56) Documents cités:
- EP-A- 0 046 096
- EP-A- 0 164 838
- EP-A- 0 217 224
- WO-A-90/16114
- WO-A-92/14305

## Description

L'invention concerne la détection de l'état de plusieurs contacteurs bipolaires utilisés chacun dans les mêmes conditions. Le circuit pouvant identifier chacun des contacteurs, une application particulièrement intéressante est prévue pour contrôler la position des portes d'inverseurs de poussée sur les turboréacteurs.

### ART ANTERIEUR

Tous les turboréacteurs utilisés sur les avions civils et militaires modernes possèdent une régulation numérique centralisée pour contrôler tous les paramètres de fonctionnement du turboréacteur en question. Dans ce système, le calculateur détermine les actions à entreprendre vers les différents organes de puissance du turboréacteur, à partir des informations qui lui sont transmises par les différents calculateurs spécifiques de l'avion, les différents capteurs, par exemple des contacteurs.

Dans ces conditions, on conçoit aisément que l'augmentation du nombre de ses entrées et sorties du calculateur se traduit par l'accroissement du nombre de contacts et de connecteurs en face avant de ce calculateur. Il s'ensuit également une augmentation de la complexité interne du calculateur. Ceci peut donc conduire à un dimensionnement du calculateur ne dépendant plus uniquement du volume occupé par l'électronique de celui-ci, mais par la surface minimale nécessaire pour la mise en place des connecteurs. On est donc amené à essayer de diminuer le nombre d'entrées physiques en face avant du calculateur, sans pour cela supprimer le nombre d'informations transmises.

Dans le cadre d'une étude sur le système inverseur de poussée à portes pour turboréacteur, visant à améliorer la fiabilité et la sécurité de ce système, il s'impose de simplifier, dans le nombre de ses connexions, le circuit de contrôle des portes.

### RESUME DE L'INVENTION

A cet effet, le premier objet principal de l'invention est un circuit de détection de la position de plusieurs contacteurs bipolaires.

Selon l'invention, les contacteurs sont montés en parallèle. Une résistance de valeur déterminée est montée en série avec chaque contacteur.
Une alimentation de tension est utilisée entre un premier point et un deuxième point. Un convertisseur analogique/numérique est connecté entre le premier et un troisième points pour fournir un signal de mesure. Un moyen de traitement du signal de mesure en question issu du convertisseur analogique/numérique est utilisé.

Dans une première réalisation, une deuxième résistance de valeur déterminée est intercalée entre chacune des branches constituées d'un contacteur et d'une résistance.

De préférence, les premières résistances ont une valeur de 2R alors que les deuxièmes résistances ont une valeur de R.

Dans une deuxième réalisation, une troisième résistance de valeur déterminée est placée entre les deux contacts de chaque contacteur.

Dans ce cas, de préférence les deuxièmes et troisièmes résistances sont de même valeur.

Un deuxième objet principal de l'invention est un dispositif de détection de la position des portes d'un inverseur de poussée sur un turboréacteur, utilisant un circuit tel qu'il vient d'être décrit, la partie mobile de chaque contact étant reliée à la porte d'un inverseur, de façon à ce que les deux positions des contacteurs soient caractéristiques des positions ouvertes et fermées des portes de l'inverseur.

### LISTE DES FIGURES

L'invention et ses différentes caractéristiques techniques seront mieux comprises à la lecture de la description, accompagnée des figures représentant respectivement :
- figure 1, un schéma du circuit selon l'invention dans sa première réalisation ;
- figure 2, un schéma du circuit selon l'invention dans sa deuxième réalisation ;
- figures 3A et 3B, deux schémas d'équivalence électrique de deux contacteurs utilisés dans la deuxième réalisation du circuit selon l'invention.

### DESCRIPTION DETAILLEE DE DEUX REALISATIONS DE L'INVENTION

### Première réalisation

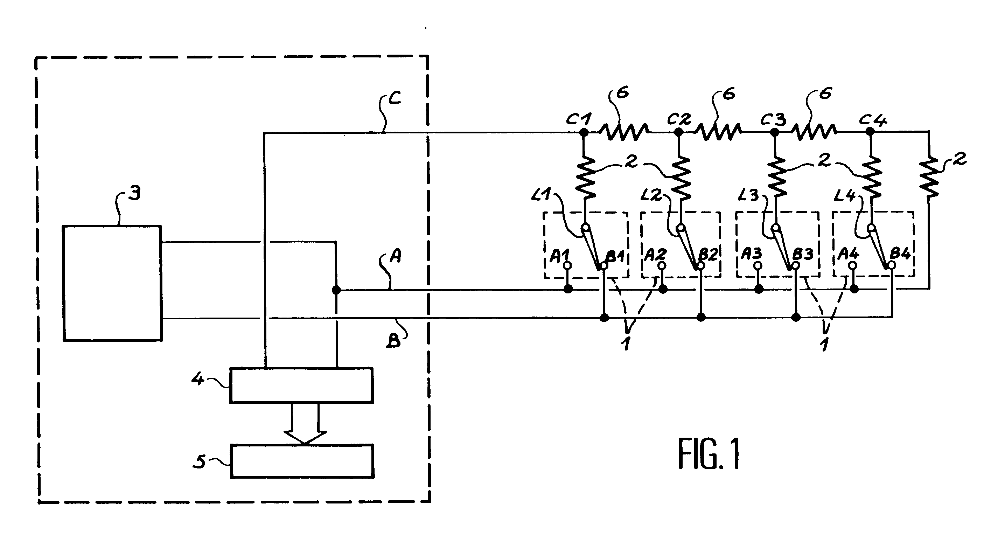

En référence à la figure 1, le circuit comprend bien entendu plusieurs contacteurs bipolaires 1, au nombre de quatre sur la figure 1. Ces contacteurs bipolaires 1 sont montés en parallèle les uns par rapport aux autres. Bien entendu, dans leur application, ils sont placés sur des éléments mobiles dont il s'agit de déterminer l'état de positionnement entre deux positions déterminées.

Chaque contacteur est composé d'un levier mobile L_{N} dont une extrémité peut être mise en contact avec soit un premier contact A_{N}, soit un deuxième contact B_{N}. Les premiers contacts A_{N} sont reliés entre eux et reliés à un premier point A. De même, les deuxièmes contacts B_{N} sont reliés entre eux et à un deuxième point B.

A chaque contacteur 1 est associée une résistance 2 montée en série avec le contacteur 1 pour constituer une branche contacteur. L'extrémité de cette branche constituée par l'extrémité libre de la résistance 2 constitue un troisième point C_{N} de la branche du contacteur. Tous troisièmes points C_{N} sont reliés entre eux et à un troisième point C.

Le circuit se complète d'une deuxième résistance 6 placée entre chaque troisième point successif C₁, C₂,..., C_{N}, c'est-à-dire entre les extrémités reliées au point C des branches contacteurs. La valeur des deuxièmes résistances est de préférence égale à la moitié R de la valeur 2R des premières résistances 2.

Le circuit possède une alimentation en tension électrique 3 qui fournit une tension entre le premier point A et le deuxième point B et par conséquent à leurs points respectifs dans chaque branche contacteur, c'est-à-dire entre chacun des deux contacts A_{N} et B_{N} de chaque contacteur 1. De plus, la branche des premiers contacts, c'est-à-dire le premier point A est connecté au troisième point C par l'intermédiaire d'une résistance 2 équivalente aux résistances utilisées dans les branches contacteurs.

Ainsi donc, la tension au point C est un signal de mesure qui est caractéristique de l'état des quatre contacteurs 1. En mesurant donc la tension entre les premiers points A et troisièmes points C, on obtient une information caractéristique de l'état de ces quatre contacteurs. Un convertisseur analogique/numérique 4 est donc utilisé à cet effet. Ses deux entrées sont connectées respectivement au premier point A et au troisième point C. La sortie de ce convertisseur 4 est reliée à une unité de traitement 5 capable d'afficher ou d'exploiter l'information détectée.

Le tableau suivant permet de comprendre comment le signal de tension entre le premier point A et le troisième point C peut être exploité, dans le cadre de l'utilisation de quatre contacteurs, numérotés de 1 à 4. Dans le cas où on applique une tension de dix volts entre le premier point A et le deuxième point B, la tension mesurée entre le premier point A et le premier point C peut varier de zéro à dix volts. Chaque valeur mesurée est un multiple d'un seizième de cette valeur de dix volts. On contaste que chacune de ces seize valeurs est différente, ce qui permet d'identifier non seulement le nombre de contacteurs ouverts ou fermés, mais d'identifier nommément les contacteurs ouverts ou fermés.

| **1** | **2** | **3** | **4** | **U(A->B) Volts** |
|---|---|---|---|---|
| 0 | 0 | 0 | 0 | 0 |
| 0 | 0 | 0 | 1 | 10/16 |
| 0 | 0 | 1 | 0 | 2*10/16 |
| 0 | 0 | 1 | 1 | 3*10/16 |
| 0 | 1 | 0 | 0 | 4*10/16 |
| 0 | 1 | 0 | 1 | 5*10/16 |
| 0 | 1 | 1 | 0 | 6*10/16 |
| 0 | 1 | 1 | 1 | 7*10/16 |
| 1 | 0 | 0 | 0 | 8*10/16 |
| 1 | 0 | 0 | 1 | 9*10/16 |
| 1 | 0 | 1 | 0 | 10*10/16 |
| 1 | 0 | 1 | 1 | 11*10/16 |
| 1 | 1 | 0 | 0 | 12*10/16 |
| 1 | 1 | 0 | 1 | 13*10/16 |
| 1 | 1 | 1 | 0 | 14*10/16 |
| 1 | 1 | 1 | 1 | 15*10/16 |

Chaque colonne est relative à un contacteur et contient la numérotation binaire de l'état du contacteur en question. On obtient ainsi seize combinaisons possibles. La première ligne des colonnes (0, 0, 0, 0) symbolise les quatre contacteurs fermés, tandis que la dernière ligne (1, 1, 1, 1) symbolise les quatre contacteurs ouverts.

La dernière colonne indique les valeurs de la tension U mesurée entre le premier point A et le troisième point C. Ces valeurs s'échelonnent de zéro à dix volts, incrémentées successivement de dix seizième de volts.

On note que la tension en fraction U mesurée entre le premier point A et le troisième C est indépendante des valeurs des résistances 2 et 6. Ceci peut avoir une importance en cas de variations de température, la dérive de chaque résistance étant la même pour toutes les résistances.

On signale qu'une résistance supplémentaire peut être placée entre le premier point A et le troisième point C, c'est-à-dire entre les deux entrées du convertisseur analogique/numérique 4.

### Deuxième réalisation

Cette réalisation comprend les mêmes éléments principaux que ceux de la première réalisation. On y retrouve en effet les contacteurs 1 montés en parallèle, une résistance 2 étant montée en série avec chacun des contacteurs 1. On y retrouve également la source d'alimentation en tension électrique 3, le convertisseur analogique/numérique 4 et le circuit de traitement 5, ces différents éléments étant reliés au circuit des contacteurs 1 de la même manière.

Par contre, le branchement des contacteurs 1 est différent. Tous les premiers contacts A_{N} sont quand même reliés entre eux et à un premier point A. De même, tous les deuxièmes contacts B_{N} sont reliés entre eux et à un deuxième point B. De manière analogue, l'autre extrémité de chaque branche contacteur C_{N} est reliée à un troisième point C.

Toutefois, une résistance 7 de valeur R équivalente à la valeur de la résistance 2 est placée entre chaque contact A_{N} et B_{N} d'un même contacteur.

Un tel circuit permet de détecter le nombre de contacteurs ouverts ou fermés. Par contre, il ne permet pas d'identifier le ou les contacteurs ouverts et le ou les contacteurs fermés.

En mesurant la résistance R_{AC} entre le premier point A et le troisième point C et la résistance R_{BC} entre le deuxième point B et le troisième point C, on obtient à chaque mesure un couple de valeurs. Connaissant la valeur des résistances 2 et 7 utilisées, il est possible de détecter les valeurs qu'on peut obtenir dans chaque combinaison d'ouverture ou de fermeture des contacteurs 1. Par contre, dans le cas où les appareils de mesure, à savoir l'unité de traitement 5, détecteraient un couple de valeurs R_{AC}, R_{BC} qui ne serait pas cohérent avec les valeurs évoquées précédemment, on pourrait en conclure à une panne ou la rupture d'un fil électrique.

Ce circuit permet donc de distinguer l'état de panne ou de coupure électrique à une position ouverte d'un ou de plusieurs contacteurs.

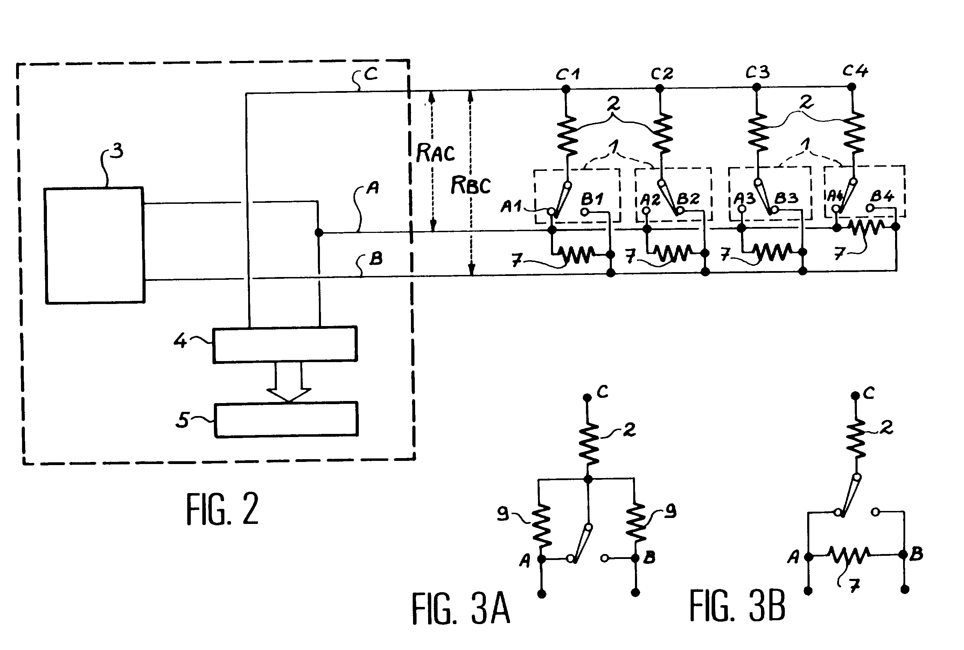

Les schémas des figures 3A et 3B montrent que la représentation du branchement des contacteurs 1 de cette deuxième réalisation est équivalente à une autre représentation, en l'occurrence celle de la figure 3B. Dans ce cas, une résistance 2 est toujours placée en série avec le contacteur. Par contre, celui-ci ne possède plus de résistance 7 reliant ces deux contacts A et B et possède une quatrième résistance 9 reliant le premier contact A à la résistance 2, et également une quatrième résistance 9 reliant le deuxième contact B à la résistance 2. Ces deux schémas des figures 3A et 3B sont électriquement équivalents.

Le tableau suivant donne en fonction du nombre n de portes fermées les couples cohérents de valeurs de résistances R_{AC}, R_{BC}.

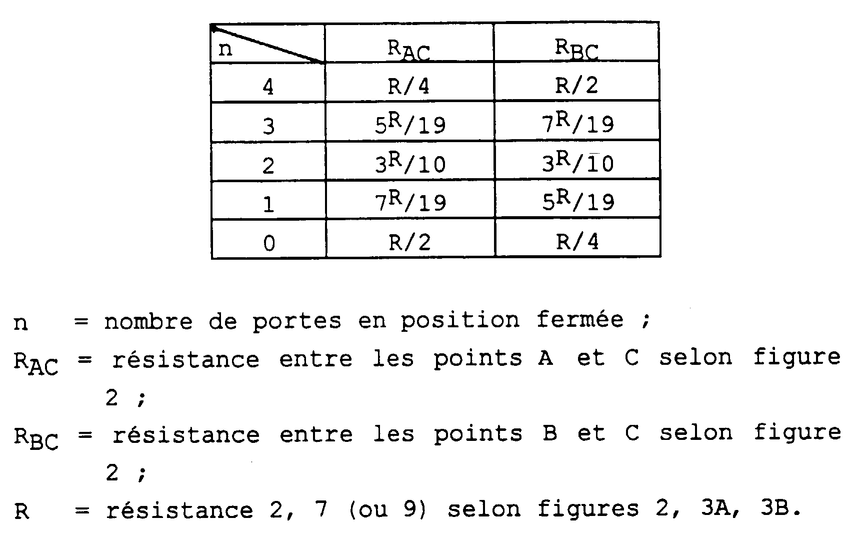

### Application à un inverseur de poussée

Il est aisé de comprendre que si les premiers contacts A_{N} et deuxièmes contacts B_{N} de ces deux réalisations du circuit selon l'invention sont des contacteurs de fin de course, placés respectivement sur des élements de turboréacteurs où viennent en contact les portes de l'inverseur de poussée, il est facile de détecter le nombre de portes effectivement ouvertes. De plus, avec la première réalisation du circuit selon l'invention, il est possible d'identifier la ou les portes ouvertes ou fermées.

On note que le circuit n'a que trois fils de connexion le reliant au calculateur. Cette proportion permet d'envisager l'accroissement du nombre de contacteurs dans le système de surveillance de fonctionnement d'un tel turboréacteur, sans avoir à ce soucier à de nombreux problèmes matériels concernant les interfaces.

Il est préférable d'utiliser, dans la réalisation du circuit selon l'invention, des résistances insensibles aux dérives thermiques. De même, la valeur des résistances sera choisie en fonction de l'électronique de traitement.

### AVANTAGES DE L'INVENTION

La conception des circuits selon l'invention permet une diminution de leurs masses totales, à fonction égale. Cette diminution de la masse est liée à la diminution du nombre de fils électriques, de contacts et de la taille des connecteurs associés. Une diminution du coût s'ensuit évidemment.

En associant cette technique à une détection de dérive de tension électrique délivrée et à une logique de traitement, il est possible de détecter le vieillissement des contacteurs, ou une panne franche et ainsi d'accroître la fiabilité et la sécurité du système.

Comme on l'a précisé précédemment, on obtient un gain sur le nombre d'entrées discrètes pour le calculateur. Il s'ensuit également la suppression d'un multiplexage d'entrées discrètes.

Dans le cas de l'utilisation de plusieurs contacteurs pour rendre compte d'un seul évènement, le circuit permet de connaître l'état de bon fonctionnement de chaque contacteur et d'éviter ainsi des pannes dormantes.

La conception du circuit selon l'invention offre la possibilité de rajouter des entrées discrètes, c'est-à-dire des contacteurs supplémentaires, sans modifier la structure du calculateur.

## Revendications

1. Circuit de détection de la position de plusieurs contacteurs bipolaires (1) sur un premier contact (A_{N}) et un deuxième contact (B_{N}),
caractérisé en ce que :
- les contacteurs (1) sont montés en parallèle ;
- une première résistance (2) de valeur déterminée est montée en série avec chaque contacteur (1) ;
- une alimentation de tension (3) est connectée entre un premier point (A) connectée à tous les premiers contacts (A_{N}) et un deuxième point (B) connecté au deuxièmes contacts (B_{N}) ;
- un convertisseur analogique/numérique (4) est connecté entre le premier point (A) et le troisième point (C), fournissant un signal de mesure ;
- un moyen de traitement du signal (5) est connecté à la sortie du convertisseur analogique/numérique (4).

2. Circuit de détection selon la revendication 1, caractérisé en ce qu'une deuxième résistance (6) de valeur déterminée est intercalée entre chacune des branches constituées d'un contacteur (1) et d'une première résistance (2) montée en série.

3. Circuit selon la revendication 2, caractérisé en que les premières résistances (2) ont une valeur déterminée égale à 2R, les deuxièmes résistances (6) ayant une valeur déterminée égale à la moitié, c'est-à-dire R.

4. Circuit selon la revendication 1, caractérisé en ce qu'une troisième résistance (7) de valeur déterminée est placée entre les deux contacts (A_{N}, B_{N}) de chaque contacteur (11).

5. Circuit selon la revendication 4, caractérisé en ce que les premières résistances (2) et les troisièmes résistances (7) ont la même valeur R.

6. Dispositif de détection de la position des portes d'un inverseur de poussée d'un turboréacteur, utilisant un circuit selon l'une des revendications précédentes, la partie mobile (L) de chaque contacteur (1) étant reliée à la porte d'un inverseur, de façon à ce que les deux positions des contacteurs (1) soient caractéristiques des positions ouvertes et fermées des portes.

## Patentansprüche

1. Schaltung zur Erfassung der Position mehrerer bipolarer Schalter (1) an einem ersten Kontakt (A_{N}) und einem zweiten Kontakt (B_{N}), **dadurch gekennzeichnet**, daß
- die Schalter (1) parallel angeordnet sind;
- ein erster Widerstand (2) mit einem bestimmten Wert in Serie mit jedem Schalter (1) geschaltet ist;
- eine Spannungsversorgung (3) zwischen einem ersten Punkt (A), der mit allen ersten Kontakten (A_{N}) verbunden ist, und einem zweiten Punkt (B) geschaltet ist, der mit allen zweiten Kontakten (B_{N}) verbunden ist;
- ein Analog-/Digital-Umsetzer (4) zwischen dem ersten Punkt (A) und einem dritten Punkt (C) geschaltet ist, der ein Meßsignal liefert; und
- eine Signalverarbeitungseinrichtung (5) mit dem Ausgang des A/D-Umsetzers (4) verbunden ist.

2. Erfassungsschaltung nach Anspruch 1,
**dadurch gekennzeichnet**, daß ein zweiter Widerstand (6) mit bestimmtem Wert zwischen den Zweigen geschaltet ist, die durch einen Schalter (1) und einem ersten Widerstand (2), die in Serie geschaltet sind, gebildet werden.

3. Schaltung nach Anspruch 2,
**dadurch gekennzeichnet**, daß die ersten Widerstände (2) einen Widerstand gleich 2R aufweisen, wobei die zweiten Widerstände (6) einen Wert gleich der Hälfte davon, d.h. R aufweisen.

4. Schaltung nach Anspruch 1,
**dadurch gekennzeichnet**, daß ein dritter Widerstand (7) mit vorbestimmtem Wert zwischen den beiden Kontakten (A_{N}, B_{N}) von jedem Schalter (11) angeordnet ist.

5. Schaltung nach Anspruch 4,
**dadurch gekennzeichnet**, daß die ersten Widerstände (2) und die dritten Widerstände (7) den gleichen Wert R aufweisen.

6. Vorrichtung zur Erfassung der Position der Klappen einer Schubumkehrvorrichtung einer Turbomaschine, die eine Schaltung nach einem der vorhergehenden Ansprüche verwendet, wobei der bewegliche Teil (L) von jedem Schalter (1) mit einer Klappe einer Umkehreinrichtung verbunden ist, so daß die beiden Positionen der Schalter (1) die offene und die geschlossene Stellung der Klappen wiedergebeben.

## Claims

1. Circuit for detecting the position of several two-pole contactors (1) on a first contact (A_{N}) and a second contact (B_{N}), characterized in that:
- the contactors (1) are mounted in parallel;
- a first resistor (2) of defined value is mounted in series with each contactor (1);
- a voltage supply (3) is connected between a first point (A) connected to all the first contacts (A_{N}) and a second point (B) connected to the second contacts (B_{N});
- an analog/digital converter (4) is connected between the first point (A) and the third point (C), supplying a measurement signal;
- a signal processing means (5) is connected to the output of the analog/digital converter (4).

2. Detection circuit according to Claim 1, characterized in that a second resistor (6) of defined value is interposed between each of the branches consisting of a contactor (1) and of a first series-mounted resistor (2).

3. Circuit according to Claim 2, characterized in that the first resistors (2) have a defined value equal to 2R, the second resistors (6) having a defined value equal to half, that is to say R.

4. Circuit according to Claim 1, characterized in that a third resistor (7) of defined value is placed between the two contacts (A_{N}, B_{N}) of each contactor (11).

5. Circuit according to Claim 4, characterized in that the first resistors (2) and the third resistors (7) have the same value, R.

6. Device for detecting the position of the doors of a thrust reverser of a jet engine, using a circuit according to one of the preceding claims, the movable part (L) of each contactor (1) being linked to the door of a reverser, in such a way that the two positions of the contactors (1) are characteristic of the open and closed positions of the doors.
